# EUROPEAN PATENT APPLICATION

(11) **EP 3 128 660 A1**
(43) Date of publication of application: **08.02.2017**
(21) Application number: 16182852.0
(22) Date of filing: 04.08.2016
(51) Int. Cl.: H02K 29/03, H02K 29/08, H02K 1/27, H02P 6/22, H02K 11/33, G01R 33/00, H02K 1/14

(54) **MAGNETIC SENSOR INTEGRATED CIRCUIT AND MOTOR ASSEMBLY**

(30) Priority: 07.08.2015 WO PCT/CN2015/086422; 01.04.2016 CN 201610204132; 02.06.2016 CN 201610392329
(71) Applicant: Johnson Electric S.A., 3280 Murten (CH)
(72) Inventor: Sun, Chi Ping, Shatin, N.T. (HK); Xin, Fei, Shatin, N.T. (HK); Wong, Ken, Shatin, N.T. (HK); Yeung, Shing Hin, Shatin, N.T. (HK); Huang, Shu Juan, Shatin, N.T. (HK); Jiang, Yun Long, Shatin, N.T. (HK); Li, Yue, Shatin, N.T. (HK); Liu, Bao Ting, Shatin, N.T. (HK); Wang, En Hui, Shatin, N.T. (HK); Yang, Xiu Wen, Shatin, N.T. (HK); Liu, Li Sheng, Shatin, N.T. (HK); Cui, Yan Yun, Shatin, N.T. (HK)
(74) Representative: Hocking, Adrian Niall

(57) **Abstract**

A magnetic sensor integrated circuit (400) and a motor assembly are provided. The integrated circuit includes a housing (2), a semiconductor substrate arranged in the housing, at least one input port (A1, A2) and an output port (Pout), and an electronic circuit arranged on the semiconductor substrate. The electronic circuit includes a rectifying circuit (60), a magnetic field detection circuit (20) configured to detect an external magnetic field and output magnetic field detection information, and an output control circuit (20) connected to the rectifying circuit (60) and configured to control, at least based on the magnetic field detection information, the integrated circuit to operate in at least one of a first state in which a load current flows from the output port (Pout) to an outside of the integrated circuit and a second state in which a load current flows from the outside of the integrated circuit to the output port (Pout). The load current flows through the rectifying circuit (60).

## Description

### FIELD

The disclosure relates to magnetic field detection technology.

### BACKGROUND

A magnetic sensor is widely used in modem industry and electronic products to measure physical parameters such as a current, a position and a direction by sensing magnetic field intensity. Motor industry is an important application field of the magnetic sensor. The magnetic sensor is used to sense a polarity position of a rotor in an electric motor.

According to the conventional technology, the magnetic sensor generally can output only a magnetic field detection result, and a peripheral circuit is required additionally to process the magnetic field detection result in practice, hence, the overall circuit has a high cost and a poor reliability.

### SUMMARY

In an aspect, a magnetic sensor integrated circuit is provided according to an embodiment of the disclosure, which includes: a housing, a semiconductor substrate arranged in the housing, at least one input port and an output port extending out from the housing, and an electronic circuit arranged on the semiconductor substrate, where the electronic circuit includes:
a rectifying circuit;
a magnetic field detection circuit configured to detect an external magnetic field and output magnetic field detection information; and
an output control circuit coupled to the rectifying circuit, and configured to control, at least based on the magnetic field detection information, the integrated circuit to operate in at least one of a first state in which a load current flows out from the output port to an outside of the integrated circuit and a second state in which a load current flows in from the outside of the integrated circuit to the output port, where the load current flows through the rectifying circuit.

Preferably, the output control circuit may be configured to control, at least based on the magnetic field detection information, the integrated circuit to switch between the first state and the second state, where both the flowing-out current and the flowing-in current flow through the rectifying circuit.

Preferably, the magnetic field detection circuit may be powered by a first power supply, and the output control circuit may be powered by a second power supply different from the first power supply.

Preferably, an average of an output voltage of the first power supply may be less than that of an output voltage of the second power supply.

Preferably, the at least one input port may include an input port configured to connect an external alternating current (AC) power supply, and the output control circuit may be configured to control, based on the magnetic field detection information and a polarity of the AC power supply, the integrated circuit to operate in at least one of the first and the second state.

Preferably, the output control circuit may include a first switch and a second switch, the first switch and the output port are connected in a first current path, the second switch and the output port are connected in a second current path having a direction opposite to that of the first current path, and the first switch and the second switch are turned on selectively based on the magnetic field detection information.

Preferably, the first switch may be a triode, and the second switch may be a diode or a triode.

Preferably, the output control circuit may include a first current path in which a current flows out from the output port, a second current path in which a current flows in from the output port, and a switch connected in one of the first current path and the second current path, wherein the switch may be configured to control, based on the magnetic field detection information outputted from the magnetic field detection circuit, the first current path and the second current path to be turned on selectively.

Preferably, no switch may be arranged in the other one of the first current path and the second current path.

Preferably, the output control circuit may be configured to control the load current to flow through the output port in a case that the AC power supply is in a positive half cycle and the external magnetic field is a first polarity or in a case that the AC power supply is in a negative half cycle and the external magnetic field is a second polarity opposite to the first polarity, and to control no load current to flow through the output port in a case that the AC power supply is in a positive half cycle and the external magnetic field is the second polarity or in a case that the AC power supply is in a negative half cycle and the external magnetic field is the first polarity.

Preferably, the at least one input port may include a first input port and a second input port configured to connect an external AC power supply, and the rectifying circuit may be configured to convert an AC electrical signal outputted from the external AC power supply into a direct current (DC) electrical signal.

Preferably, the integrated circuit may further include a voltage regulator configured to adjust a first voltage outputted from the rectifying circuit to a second voltage, the second voltage is a supply voltage of the magnetic field detection circuit, the first voltage is a supply voltage of the output control circuit, and an average of the first voltage is greater than that of the second voltage.

Preferably, the rectifying circuit may include a full wave bridge rectifier and a voltage stabilizer connected in series with the full wave bridge rectifier, the voltage stabilizer includes a Zener diode connected between two output terminals of the full wave bridge rectifier, the full wave bridge rectifier includes a first diode and a second diode connected in series and a third diode and a fourth diode connected in series, a common terminal of the first diode and the second diode is electrically connected to the first input port, and a common terminal of the third diode and the fourth diode is electrically connected to the second input port, where
a ground output terminal of the full wave bridge rectifier is formed by electrically connecting an input terminal of the first diode to an input terminal of the third diode, a voltage output terminal of the full wave bridge rectifier is formed by electrically connecting an output terminal of the second diode to an output terminal of the fourth diode, the Zener diode is connected between a common terminal of the second diode and the fourth diode and a common terminal of the first diode and the third diode.

Preferably, the rectifying circuit may have a voltage output terminal and a ground output terminal, the output control circuit being coupled to the voltage output terminal and the ground output terminal, the load current flowing through the first input port, the rectifying circuit, the voltage output terminal and the output control circuit in turn and flowing from the output port to the outside of the integrated circuit in a case that the integrated circuit operates in the first state, and/or the load current flowing through the output port, the output control circuit, the ground output terminal, the rectifying circuit and the first input port in turn in a case that the integrated circuit operates in the second state.

Preferably, the magnetic field detection circuit may include:
a magnetic field detection element configured to detect and convert the external magnetic field into an electrical signal;
a signal processing unit configured to amplify and descramble the electrical signal; and
a conversion unit configured to convert the amplified and descrambled electrical signal into the magnetic field detection information which is a switch-type digital signal.

Preferably, the at least one input port may include a first input port and a second input port configured to connect an external AC power supply to the magnetic sensor integrated circuit, and an occurrence frequency of the first state or the second state may be proportional to a frequency of the AC power supply.

Preferably, the rectifying circuit, the magnet field detection circuit and the output control circuit are formed in a single one bare die.

In another aspect, a motor assembly is provided according to an embodiment of the disclosure, which includes:
a motor; and
a motor drive circuit comprising the magnetic sensor integrated circuit described above.

Preferably, the motor drive circuit may further include a bidirectional switch connected in series with the motor across the external AC power supply; and
the output port of the magnetic sensor integrated circuit may be connected to a control terminal of the bidirectional switch.

Preferably, the motor may include a stator and a permanent rotor, the stator may include a stator core and a single-phase winding wound on the stator core.

Preferably, the motor assembly may further include a voltage dropping circuit configured to reduce a voltage of the AC power supply and provide the reduced voltage of the AC power supply to the magnetic sensor integrated circuit.

Preferably, the output control circuit may be configured to control a drive current to flow between the output port and the bidirectional switch and control the bidirectional switch to be turned on in a case that the AC power supply is in a positive half cycle and a magnetic field of the permanent rotor is a first polarity or in a case that the AC power supply is in a negative half cycle and the magnetic field of the permanent rotor is a second polarity opposite to the first polarity, and to control the bidirectional switch to be turned off in a case that the AC power supply is in a negative half cycle and the magnetic field of the permanent rotor is the first polarity or in a case that the AC power supply is in a positive half cycle and the magnetic field of the permanent rotor is the second polarity opposite to the first polarity.

Preferably, the output control circuit may be configured to control a current to flow from the integrated circuit to the bidirectional switch in a case that a signal outputted from the AC power supply is in a positive half cycle and the magnetic field of the permanent rotor is the first polarity, and/or control a current to flow from the bidirectional switch to the integrated circuit in a case that the signal outputted from the AC power supply is in a negative half cycle and the magnetic field of the permanent rotor is the second polarity.

A function of the existing magnetic sensor is extended with the magnetic sensor integrated circuit according to the embodiments of the present disclosure. The overall circuit cost is reduced and the reliability of the circuit is improved.

### BRIEF DESCRIPTION OF THE DRAWINGS

The drawings to be used in the description of embodiments of the disclosure or the conventional technology are described briefly as follows, so that technical solutions according to the embodiments of the present disclosure or according to the conventional technology become clearer. It is apparent that the drawings in the following description only illustrate some embodiments of the present disclosure. For those skilled in the art, other drawings may be obtained according to these drawings without any creative work.
Figure 1 is a schematic structural diagram of a magnetic sensor integrated circuit according to an embodiment of the present disclosure;
Figure 2 is a schematic structural diagram of a magnetic sensor integrated circuit according to an embodiment of the present disclosure;
Figure 3 is a schematic structural diagram of an output control circuit in a magnetic sensor integrated circuit according to an embodiment of the present disclosure;
Figure 4 is a schematic structural diagram of an output control circuit in a magnetic sensor integrated circuit according to an embodiment of the present disclosure;
Figure 5 is a schematic structural diagram of an output control circuit in a magnetic sensor integrated circuit according to an embodiment of the present disclosure;
Figure 5A is a schematic structural diagram of an output control circuit in a magnetic sensor integrated circuit according to an embodiment of the present disclosure;
Figure 6 is a schematic structural diagram of a magnetic sensor integrated circuit according to an embodiment of the present disclosure;
Figure 7 is a schematic structural diagram of a magnetic sensor integrated circuit according to an embodiment of the present disclosure;
Figure 8 is a schematic structural diagram of a rectifying circuit in a magnetic sensor integrated circuit according to an embodiment of the present disclosure;
Figure 9 is a schematic structural diagram of a magnetic field detection circuit in a magnetic sensor integrated circuit according to an embodiment of the present disclosure;
Figure 10 is a schematic structural diagram of a motor assembly according to an embodiment of the present disclosure; and
Figure 11 is a schematic structural diagram of a motor in a motor assembly according to an embodiment of the present disclosure.

### DETAILED DESCRIPTION OF EMBODIMENTS

Technical solutions according to embodiments of the present disclosure are described clearly and completely in conjunction with the drawings in the embodiments of the present disclosure hereinafter. Apparently, the described embodiments are only a few rather than all of the embodiments of the present disclosure. Other embodiments obtained by those skilled in the art without any creative work based on the embodiments of the present disclosure fall into the scope of protection of the present disclosure.

More specific details are set forth in the following descriptions for sufficient understanding of the disclosure, but the present disclosure may further be implemented by other ways different from the way described herein. Similar extensions can be made by those skilled in the art without departing from the spirit of the present disclosure, and therefore, the present disclosure is not limited to particular embodiments disclosed hereinafter.

Hereinafter, a magnetic sensor integrated circuit according to an embodiment of the present disclosure is explained by taking the magnetic sensor integrated circuit being applied in a motor as an example.

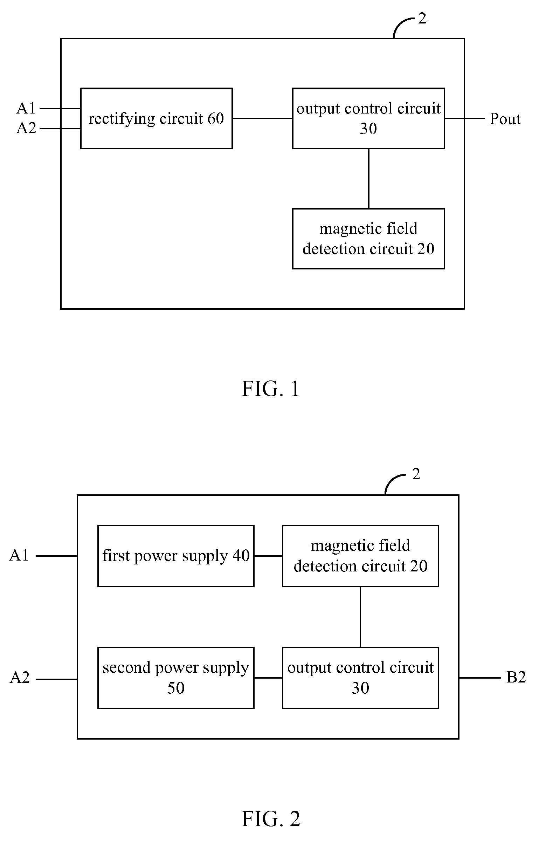

As shown in Figure 1, a magnetic sensor integrated circuit is provided according to an embodiment of the present disclosure. The integrated circuit includes a housing 2, a semiconductor substrate (not shown) arranged in the housing, input ports A1, A2, an output port Pout extending out from the housing, and an electronic circuit arranged on the semiconductor substrate. The input ports are configured to connect an external power supply to the magnetic sensor integrated circuit. The electronic circuit includes:
a rectifying circuit 60 coupled to the input ports;
a magnetic field detection circuit 20 coupled to the rectifying circuit 60, configured to detect an external magnetic field and output magnetic field detection information; and
an output control circuit 30 coupled to the rectifying circuit 60, and configured to control, at least based on the magnetic field detection information, the integrated circuit to operate in at least one of a first state in which a load current flows out from the output port to an outside of the integrated circuit and a second state in which a load current flows in from the outside of the integrated circuit to the output port, where the load current flows through the rectifying circuit 60.

On the basis of the above-described embodiment, in a preferred embodiment of the present disclosure, the output control circuit 30 is configured to control, at least based on the magnetic field detection information, the integrated circuit to switch between the first state in which a load current flows out from the output port to the outside of the integrated circuit and the second state in which a load current flows in from the outside of the integrated circuit to the output port, where both the flowing-out current and the flowing-in current flow through the rectifying circuit, which is not limited thereto in the present disclosure, as the case may be.

It should be noted that, in an embodiment of the disclosure, the switching of the magnetic sensor integrated circuit between the first state and the second state is not limited to a case that the magnetic sensor integrated circuit switches to a state as soon as the other state ends, but further includes a case that the magnetic sensor integrated circuit waits for an interval time to switch to a state after the other state ends. In a preferred embodiment, there is no output in the output port of the magnetic sensor integrated circuit within the interval time in switching between the two states.

On the basis of the above-described embodiment, in an embodiment of the present disclosure, as shown in Figure 2, the magnetic field detection circuit 20 is powered by a first power supply 40, and the output control circuit 30 is powered by a second power supply 50 different from the first power supply 40. It should be noted that, in an embodiment of the present disclosure, the second power supply 50 may be a power supply with a variable amplitude or a DC power supply with a constant amplitude. Preferably, in a case of a power supply with a variable amplitude, the second power supply 50 is a DC power supply with a variable amplitude, which is not limited thereto in the present disclosure, as the case may be.

On the basis of the above-described embodiment, in an embodiment of the present disclosure, the first power supply 40 is a DC power supply with a constant amplitude, to provide a stable voltage to the magnetic field detection circuit 20, so that the magnetic field detection circuit 20 operates stably.

On the basis of the above-described embodiment, in a preferred embodiment of the present disclosure, an average of an output voltage of the first power supply 40 is less than that of an output voltage of the second power supply 50. It should be noted that, the magnetic field detection circuit 20 is powered by a power supply with low power consumption, and thus the power consumption of the integrated circuit is reduced; while the output control circuit 30 is powered by a power supply with high power consumption, and thus the output port provides a high load current to ensure the integrated circuit to have enough drive capability.

On the basis of the above-described embodiment, in an embodiment of the present disclosure, the output control circuit 30 includes a first switch and a second switch. The first switch and the output port are connected in a first current path. The second switch and the output port are connected in a second current path having a direction opposite to that of the first current path. The first switch and the second switch are turned on selectively based on the magnetic field detection information. Preferably, the first switch may be a triode, and the second switch may be a triode or a diode, which is not limited thereto in the present disclosure, as the case may be.

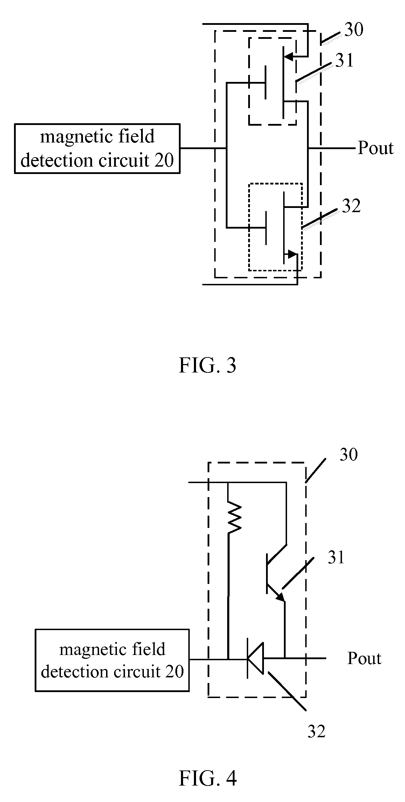

Specifically, in an embodiment of the present disclosure, as shown in Figure 3, the first switch 31 and the second switch 32 are a pair of complementary semiconductor switches. The first switch 31 is turned on at a low level, and the second switch 32 is turned on at a high level. The first switch 31 and the output port Pout are connected in a first current path, and the second switch 32 and the output port Pout are connected in a second current path. Both a control terminal of the first switch 31 and a control terminal of the second switch 32 are connected to the magnetic field detection circuit 20. A current input terminal of the first switch 31 is connected to a high voltage (such as a DC power supply), a current output terminal of the first switch 31 is connected to a current input terminal of the second switch 32, and a current output terminal of the second switch 32 is connected to a low voltage (such as the ground). In a case that magnetic field detection information outputted from the magnetic field detection circuit 20 is a low level, the first switch 31 is turned on, and the second switch 32 is turned off, so that the load current flows from the high voltage terminal to an outside of the integrated circuit through the first switch 31 and the output port Pout. In a case that magnetic field detection information outputted from the magnetic field detection circuit 20 is a high level, the second switch 32 is turned on, and the first switch 31 is turned off, so that the load current flows from the outside of the integrated circuit to the output port Pout through the second switch 32. In the instance shown in Figure 3, the first switch 31 is a positive channel metal oxide semiconductor field effect transistor (P-type MOSFET), and the second switch 32 is a negative channel metal oxide semiconductor field effect transistor (N-type MOSFET). It is to be understood that, in other embodiments, the first switch and the second switch may be other types of semiconductor switches, for example, other field effect transistors such as junction-type field effect transistor (JFET) or metal semiconductor field effect transistor (MESFET).

In another embodiment of the present disclosure, as shown in Figure 4, the first switch 31 is a switch transistor which is turned on at a high level, the second switch 32 is a unidirectional diode, and a control terminal of the first switch 31 and a cathode of the second switch 32 are connected to the magnetic field detection circuit 20. The current input terminal of the first switch 31 is connected to the second power supply 50, and the current output terminal of the first switch 31 and an anode of the second switch 32 each are connected to the output port Pout. The first switch 31 and the output port Pout are connected in the first current path, and the output port Pout, the second switch 32 and the magnetic field detection circuit 20 are connected in the second current path. In a case that the magnetic field detection information outputted from the magnetic field detection circuit 20 is a high level, the first switch 31 is turned on, and the second switch 32 is turned off, so that the load current flows from the second power supply 50 to the outside of the integrated circuit through the first switch 31 and the output port Pout. In a case that the magnetic field detection information outputted from the magnetic field detection circuit 20 is a low level, the second switch 32 is turned on, and the first switch 31 is turned off, so that the load current flows from the outside of the integrated circuit to the output port Pout through the second switch 32. It can be understood that, in other embodiments of the present disclosure, the first switch 31 and the second switch 32 may have other structures, which is not limited thereto in the present disclosure, as the case may be.

In another embodiment of the present disclosure, the output control circuit 30 includes a first current path in which a current flows out from the output port, a second current path in which current flows in from the output port, and a switch connected in one of the first current path and the second current path. The switch is configured to control, based on the magnetic field detection information outputted from the magnetic field detection circuit, the first current path and the second current path to be turned on selectively. Optionally, no switch is arranged in the other one of the first current path and the second current path.

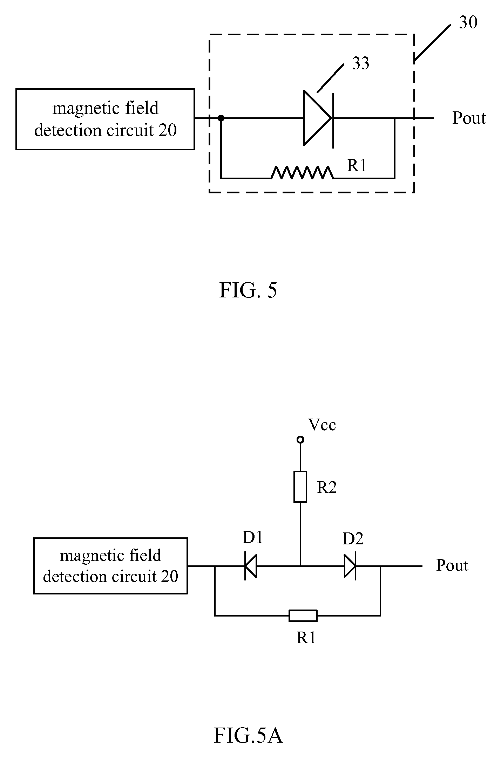

As an embodiment, as shown in Figure 5, the output control circuit 30 includes an unidirectional switch 33. The unidirectional switch 33 and the output port Pout are connected in the first current path. A current input terminal of the unidirectional switch 33 may be connected to an output terminal of the magnetic field detection circuit 20, and the output terminal of the magnetic field detection circuit 20 and the output port Pout are further connected through a resistor R1 in the second current path having a direction opposite to that of the first current path. The unidirectional switch 33 is turned on in a case that a magnetic field sensing signal is a high level signal, so that the load current flows to the outside of the integrated circuit through the unidirectional switch 33 and the output port Pout. The unidirectional switch 33 is turned off in a case that the magnetic field sensing signal is a low level signal, so that the load current flows from the outside of the integrated circuit to the output port Pout and flows through the resistor R1 and the magnetic field detection circuit 20. Alternatively, the resistor R1 in the second current path may be replaced by another unidirectional switch connected in reverse-parallel with a unidirectional switch 33. In this way, the load current flowing out from the output port and the load current flowing in the output port are balanced.

In another embodiment, as shown in Figure 5A, the output control circuit 30 includes diodes D1 and D2 connected in reverse-series between the output terminal of the magnetic field detection circuit 20 and the output port Pout, a resistor R1 connected in parallel with the diodes D1 and D2 connected in series, and a resistor R2 connected between a common terminal of the diodes D1 and D2 and a power supply Vcc. A cathode of the diode D1 is connected to the output terminal of the magnetic field detection circuit 20. The power supply Vcc may be connected to the voltage output terminal of the rectifying circuit. The diode D1 is controlled based on the magnetic field detection information. In a case that the magnetic field detection information is a high level, the diode D1 is turned off, so that the load current flows from the output port Pout to the outside of the integrated circuit through the resistor R2 and the diode D2. In a case that the magnetic field detection information is a low level, the load current flows from the outside of the integrated circuit to the output port Pout and flows through the resistor R1 and the magnetic field detection circuit 20.

On the basis of any one of the above-described embodiments, in an embodiment of the present disclosure, the input ports include a first input port and a second input port configured to connect an external AC power supply to the magnetic sensor integrated circuit, the output control circuit 30 is configured to control, based on the magnetic field detection information and a polarity of the AC power supply, the integrated circuit to switch between the first state and the second state. Optionally, the magnetic field detection circuit 20 may be powered by a same power supply as the output control circuit 30.

On the basis of the above-described embodiment, in an embodiment of the present disclosure, the output control circuit 30 is configured to control the load current to flow through the output port in a case that the AC power supply is in a positive half cycle and the external magnetic field is detected by the magnetic field detection circuit 20 to have a first polarity or in a case that the AC power supply is in a negative half cycle and the external magnetic field is detected by the magnetic field detection circuit 20 to have a second polarity opposite to the first polarity, or to control no load current to flow through the output port in a case that the AC power supply is in a positive half cycle and the external magnetic field is detected by the magnetic field detection circuit to have a second polarity or in a case that the AC power supply is in a negative half cycle and the external magnetic field is detected by the magnetic field detection circuit to have a first polarity opposite to the second polarity. It is to be noted that, in a case that the AC power supply is in a positive half cycle and the external magnetic field is detected by the magnetic field detection circuit to have a first polarity, or in a case that the AC power supply is in a negative half cycle and the external magnetic field is detected by the magnetic field detection circuit to have a second polarity opposite to the first polarity, the load current flowing through the output port includes the case in which there is load current flowing through the output port during the entire time period and the case in which there is load current flowing through the output port for only part of the time period.

On the basis of the above-described embodiment, in an embodiment of the present disclosure, the input ports may include a first input port and a second input port configured to connect an external AC power supply to the magnetic sensor integrated circuit. In the present disclosure, the input port being connected to the external power supply includes a case in which the input port is connected to two terminals of the external power supply directly, and a case in which the input port is connected in series with an external load across two terminals of the external power supply, which is not limited thereto in the present disclosure, as the case may be. In a preferred embodiment of the present disclosure, the rectifying circuit 60 is configured to convert an AC signal outputted from the external AC power supply 70 into a DC signal.

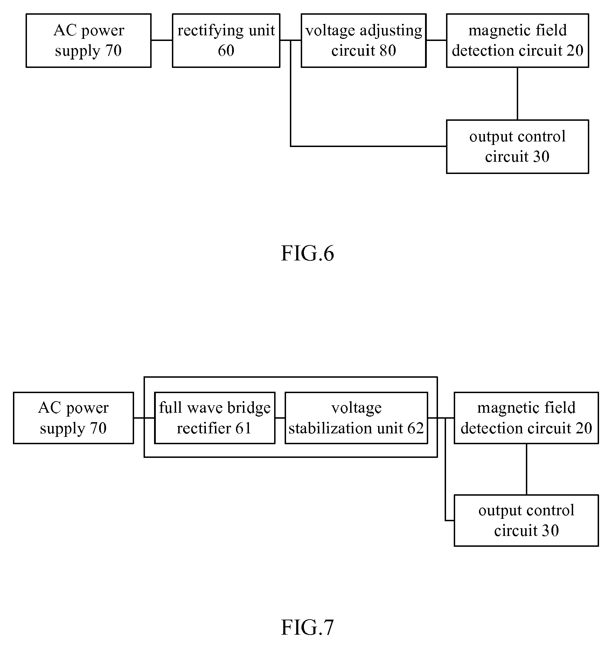

On the basis of the above-described embodiment, in a preferred embodiment of the present disclosure, as shown in Figure 6, the integrated circuit further includes a voltage regulator 80 arranged between the rectifying circuit (also referred to as rectifying unit) 60 and the magnetic field detection circuit 20. In this embodiment, the rectifying circuit 60 may serve as the second power supply 50, and the voltage adjustment circuit 80 may serve as the first power supply 40. The voltage regulator 80 is configured to adjust a first voltage outputted from the rectifying circuit 60 to a second voltage and is preferably a buck regulator. The second voltage is a supply voltage of the magnetic field detection circuit 20, the first voltage is a supply voltage of the output control circuit 30, and an average of the first voltage is greater than that of the second voltage to reduce the power consumption of the integrated circuit and ensure the integrated circuit to have enough driving capability.

In an embodiment of the present disclosure, as shown in Figure 7, the rectifying circuit 60 includes a full wave bridge rectifier 61 and a voltage stabilizer (also referred to as voltage stabilization unit) 62 connected between output terminals of the full wave bridge rectifier 61. The full wave bridge rectifier 61 is configured to convert an alternating current voltage outputted from the AC power supply 70 into a direct current voltage, and the voltage stabilizer 62 is configured to stabilize the direct current voltage outputted from the full wave bridge rectifier 61 within a preset value range.

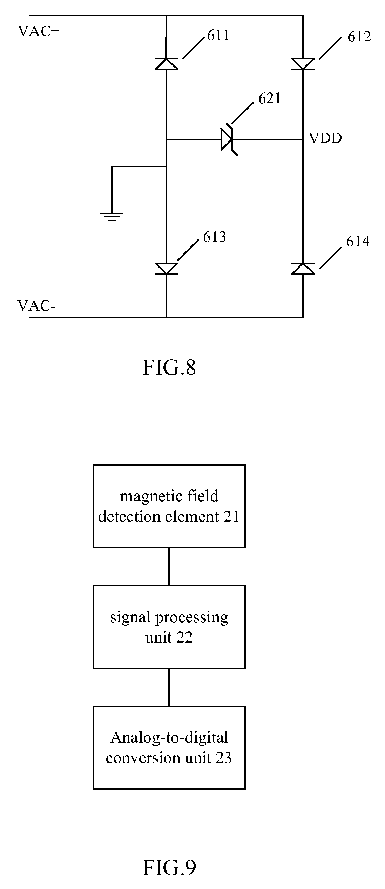

Figure 8 shows an exemplified circuit of the rectifying circuit 60. The voltage stabilizer 62 includes a Zener diode 621 connected between two output terminals of the full wave bridge rectifier 61. The full wave bridge rectifier 61 includes a first diode 611 and a second diode 612 connected in series and a third diode 613 and a fourth diode 614 connected in series. A common terminal of the first diode 611 and the second diode 612 is electrically connected to the first input port VAC+, and a common terminal of the third diode 613 and the fourth diode 614 is electrically connected to the second input port VAC-.

A common terminal of an input terminal of the first diode 611 and an input terminal of the third diode 613 forms a ground output terminal of the full wave bridge rectifier. A common terminal of an output terminal of the second diode 612 and an output terminal of the fourth diode 614 forms a voltage output terminal VDD of the full wave bridge rectifier. The Zener diode 621 is connected between the common terminal of the second diode 612 and the fourth diode 614 and the common terminal of the first diode 611 and the third diode 613. In an embodiment of the present disclosure, a power terminal of the output control circuit 30 may be electrically connected to the voltage output terminal of the full wave bridge rectifier 61.

On the basis of any one of the above-described embodiments, in an embodiment of the present disclosure, as shown in Figure 9, the magnetic field detection circuit 20 includes: a magnetic field detection element 21 configured to detect and convert the external magnetic field into an electrical signal; a signal processing unit 22 configured to amplify and descramble the electrical signal; and an analog-to-digital conversion unit 23 configured to convert the amplified and descrambled electrical signal into the magnetic field detection information which may be a switch-type digital signal for an application of only requiring to identify a polarity of a magnetic field of the external magnetic field. Preferably, the magnetic field detection element 21 may be a Hall plate.

In a preferred embodiment, in a case that the input ports includes a first input port and a second input port configured to connect an external AC power supply to the magnetic sensor integrated circuit, an occurrence frequency of the first state or the second state is proportional to a frequency of the AC power supply. It is to be understood that, the present disclosure is not limited thereto.

Hereinafter, the magnetic sensor integrated circuit according to the embodiment of the present disclosure is described in conjunction with a specific application.

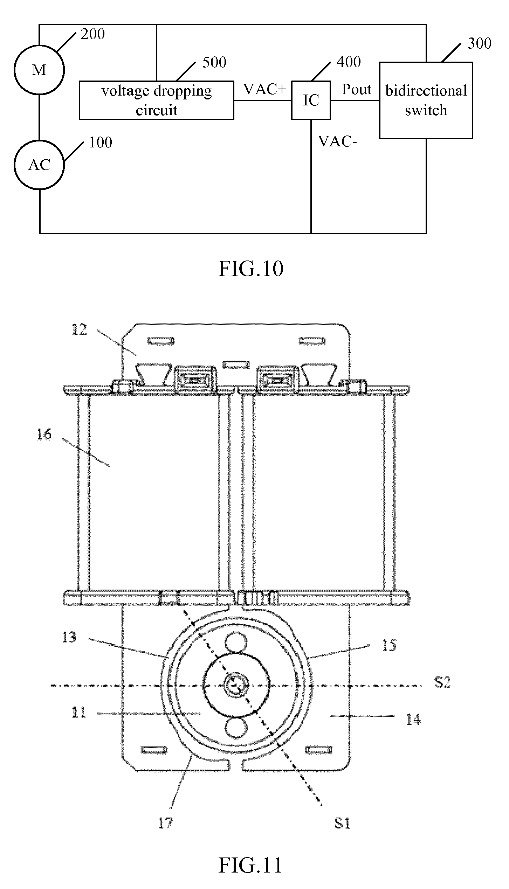

As shown in Figure 10, a motor assembly is further provided according to an embodiment of the present disclosure. The motor assembly includes: a motor 200 powered by an AC power supply 100, a bidirectional switch 300 connected in series with the motor 200, and the magnetic sensor integrated circuit 400 according to any one of the above-described embodiments. The output port of the magnetic sensor integrated circuit 400 is electrically connected to a control terminal of the bidirectional switch 300. Preferably, the bidirectional switch 300 may be a triode AC semiconductor switch (TRIAC). It is to be understood that, the bidirectional switch may be implemented as other types of suitable switches. For example, the bidirectional switch may include two silicon controlled rectifiers connected in reverse-parallel and a control circuit configured to control the two silicon controlled rectifiers in a predetermined manner based on the output signal from the output port of the magnetic sensor integrated circuit.

Preferably, the motor assembly further includes a voltage dropping circuit 500 configured to reduce a voltage of the AC power supply 100 and provide the reduced voltage to the magnetic sensor integrated circuit 400. The magnetic sensor integrated circuit 400 is arranged near a rotor of the motor 200 to sense change in a magnetic field of the rotor.

On the basis of the above-described embodiment, in an embodiment of the present disclosure, the motor is a synchronous motor. It is to be understood that, the drive circuit according to the disclosure is not only applied to the synchronous motor, but is also applied to other suitable types of permanent magnet motor. As shown in Figure 11, the synchronous motor includes a stator and a rotor 11 rotatable relative to the stator. The stator includes a stator core 12 and a stator winding 16 wound on the stator core 12. The stator core 12 may be made of soft magnetic materials such as pure iron, cast iron, cast steel, electrical steel, silicon steel. The rotor 11 includes a permanent magnet. The rotor 11 operates at a constant rotational speed of 60f/p revs/min during a steady state phase in a case that the stator winding 16 is connected in series with an AC power supply, where f is a frequency of the AC power supply and p is the number of pole pairs of the rotor. In the embodiment, the stator core 12 includes two poles 14 opposite to each other. Each of the poles 14 includes a pole arc 15, an outer surface of the rotor 11 is opposite to the pole arc 15, and a substantially uniform air gap 13 is formed between the outer surface of the rotor 11 and the pole arc 15. The "substantially uniform air gap" in the present disclosure means that a uniform air gap is formed in most space between the stator and the rotor, and a non-uniformed air gap is formed in a small part of the space between the stator and the rotor. Preferably, a starting groove 17 which is concave may be disposed in the pole arc 15 of the pole of the stator, and a part of the pole arc 15 rather than the starting groove 17 may be concentric with the rotor. With the configuration described above, the non-uniform magnetic field may be formed, a polar axis S 1 of the rotor has an angle of inclination relative to a central axis S2 of the pole of the stator in a case that the rotor is at rest, and the rotor may have a starting torque every time the motor is energized under the action of the integrated circuit. Specifically, the "pole axis S 1 of the rotor" refers to a boundary between two magnetic poles having different polarities, and the "central axis S2 of the pole 14 of the stator" refers to a connection line passing central points of the two poles 14 of the stator. In the embodiment, both the stator and the rotor include two magnetic poles. It can be understood that the number of magnetic poles of the stator may not be equal to the number of magnetic poles of the rotor, and the stator and the rotor may have more magnetic poles, such as 4 or 6 magnetic poles in other embodiments. It should be understandable that other type of non-uniformed air gap may be alternatively formed between the rotor and the stator.

On the basis of the above-described embodiment, in an embodiment of the present disclosure, the output control circuit 30 is configured to control the bidirectional switch 300 to be turned on in a case that the AC power supply 100 is in a positive half cycle and a magnetic field of the permanent rotor is detected by the magnetic field detection circuit 20 to have a first polarity or in a case that the AC power supply 100 is in a negative half cycle and a magnetic field of the permanent rotor is detected by the magnetic field detection circuit 20 to have a second polarity opposite to the first polarity, or to control the bidirectional switch 300 to be turned off in a case that the AC power supply 100 is in a negative half cycle and a magnetic field of the permanent rotor is detected by the magnetic field detection circuit 20 to have a first polarity or in a case that the AC power supply 100 is in a positive half cycle and a magnetic field of the permanent rotor is detected by the magnetic field detection circuit 20 to have a second polarity opposite to the first polarity.

Preferably, the output control circuit 30 is configured to control a current to flow from the integrated circuit to the bidirectional switch 300 in a case that a signal outputted from the AC power supply 100 is in a positive half cycle and a magnetic field of the permanent rotor is detected by the magnetic field detection circuit 20 to have the first polarity, or control a current to flow from the bidirectional switch 300 to the integrated circuit in a case that the signal outputted from the AC power supply 100 is in a negative half cycle and a magnetic field of the permanent rotor is detected by the magnetic field detection circuit 20 to have the second polarity opposite to the first polarity. It is to be understood that, in a case that the permanent rotor is in the first magnetic polarity and the AC power supply is in a positive half cycle, or in a case that the permanent rotor is in the second magnetic polarity and the AC power supply is in a negative half cycle, the current flowing out from or into the integrated circuit includes the case in which there is load current flowing through for the entire time period and the case in which there is a load current flowing through for only part of the time period.

In a preferred embodiment of the present disclosure, the bidirectional switch 300 is implemented as a triode AC semiconductor switch (TRIAC), the rectifying circuit 60 is implemented as a circuit as shown in Figure 8, and an output control circuit is implemented as a circuit as shown in Figure 4. A current input terminal of the first switch 31 in the output control circuit 30 is connected to a voltage output terminal of the full wave bridge rectifier 61, and a current output terminal of the second switch 32 is connected to a ground output terminal of the full wave bridge rectifier 61. In a case that a signal outputted from the AC power supply 100 is in a positive half cycle and the magnetic field detection circuit 20 outputs a low level, the first switch 31 is turned on and the second switch 32 is turned off in the output control circuit 30, a current flows through the AC power supply 100, the motor 200, a first input terminal of the integrated circuit 400, a voltage dropping circuit, an output terminal of the second diode 612 of the full wave bridge rectifier 61, the first switch 31 of the output control circuit 30 in turn, from the output port to the bidirectional switch 300 and back to the AC power supply 100. When the TRIAC 300 is turned on, the series branch formed by the voltage dropping circuit 500 and the magnetic sensor integrated circuit 400 is shorted, the magnetic sensor integrated circuit 400 stops outputting due to absent of the supply voltage, and the TRIAC 300 is still turned on in a case that there is no driving current between the control electrode and the first anode of the TRIAC 300 since the current flowing between the two anodes of the TRIAC 300 is high enough (higher than its holding current). In a case that the signal outputted from the AC power supply 100 is in a negative half cycle and the magnetic field detection circuit 20 outputs a high level, the first switch 31 is turned off and the second switch 32 is turned on, the current flows out from the AC power supply 100, from the bidirectional switch 300 to the output port, through the second switch 32 of the output control circuit 30, the ground output terminal and the first diode 611 of the full wave bridge rectifier 61, the first input terminal of the integrated circuit 400, the motor 200 and back to the AC power supply 100. Likewise, when the TRIAC 300 is turned on, the magnetic sensor integrated circuit 400 stops outputting because of being shorted, and the TRIAC 300 may still be turned on. The first switch 31 and the second switch 32 in the output control circuit 30 can neither be turned on, and the TRIAC 300 is turned off, in a case that the signal outputted from the AC power supply 100 is in the positive half cycle and the magnetic field detection circuit 20 outputs a high level or in a case that the signal outputted from the AC power supply 100 is in the negative half cycle and the magnetic field detection circuit 20 outputs a low level. Therefore, the output control circuit 30 can control, based on a polarity of the AC power supply 100 and the magnetic field detection information, the integrated circuit to control the bidirectional switch 300 to be switched between a turn-on state and a turn-off state in a preset way, thereby controlling an energizing mode of the stator winding 16 so that a changed magnetic field generated by the stator fits a position of a magnetic field of the rotor and drags the rotor to rotate in a single direction, thereby enabling the rotor to rotate in a fixed direction every time the motor is energized.

In a motor assembly according to another embodiment, a first series branch may be formed by the motor and the bidirectional switch, and a second series branch may be formed by the voltage dropping circuit and the magnetic sensor integrated circuit and may be connected in parallel with the first series branch between the two terminals of the AC power supply. The output port of the magnetic sensor integrated circuit is connected to the bidirectional switch, to control the bidirectional switch to switch between a turn-on state and a turn-off state in a predetermined way, thereby controlling the energizing mode of the stator winding.

The motor assembly according to the embodiment of the disclosure may be applied but not limited to devices such as a pump, a fan, a household appliance or a vehicle. The household appliance may be for example a laundry machine, a dish-washing machine, a smoke exhauster and an exhaust fan.

It should be noted that, an application field of the integrated circuit according to the embodiment of the present is not limited herein, although the embodiments of the present disclosure is explained by taking the integrated circuit being applied to the motor as an example.

It should be noted that, the parts in this specification are described in a progressive way, each of which emphasizes the differences from others, and the same or similar parts among the parts can be referred to each other.

It should be noted that the relationship terminologies such as "first", "second" and the like are only used herein to distinguish one entity or operation from another, rather than to necessitate or imply that an actual relationship or order exists between the entities or operations. Furthermore, terms of "include", "comprise" or any other variants are intended to be non-exclusive. Therefore, a process, method, article or device including a plurality of elements includes not only the disclosed elements but also other elements that are not clearly enumerated, or also include inherent elements of the process, method, article or device. Unless expressively limited otherwise, the statement "including a..." does not exclude the case that other similar elements may exist in the process, method, article or device other than enumerated elements.

The description of the embodiments herein enables those skilled in the art to implement or use the present disclosure. Numerous modifications to the embodiments are apparent to those skilled in the art, and the general principles defined herein can be implemented in other embodiments without deviating from the spirit or scope of the present disclosure. Therefore, the present disclosure may not be limited to the embodiments described herein, but is in accordance with the widest scope consistent with the principles and novel features disclosed herein.

## Claims

1. A magnetic sensor integrated circuit (400), comprising:
a housing (2),
a semiconductor substrate arranged in the housing,
at least one input port (A1, A2) and an output port (Pout) extending out from the housing, the at least one input port being configured to connect an external power, and
an electronic circuit arranged on the semiconductor substrate,
wherein the electronic circuit comprises:
a rectifying circuit (60);
a magnetic field detection circuit (20) configured to detect an external magnetic field and output magnetic field detection information; and
an output control circuit (30) coupled to the rectifying circuit (60) and configured to control, at least based on the magnetic field detection information, the integrated circuit (400) to operate in at least one of a first state in which a load current flows out from the output port (Pout) to an outside of the integrated circuit and a second state in which a load current flows in from the outside of the integrated circuit to the output port (Pout), wherein the load current flows through the rectifying circuit (60).

2. The integrated circuit according to claim 1, wherein the output control circuit (30) is configured to control, at least based on the magnetic field detection information, the integrated circuit (400) to switch between the first state and the second state, wherein both the flowing-out current and the flowing-in current flow through the rectifying circuit (60).

3. The integrated circuit according to claim 1 or 2, wherein
the magnetic field detection circuit (20) is powered by a first power supply (40), and
the output control circuit (30) is powered by a second power supply (50) different from the first power supply (40).

4. The integrated circuit according to claim 1 or 2 or 3, wherein
the at least one input port (A1, A2) comprises an input port configured to connect an external alternating current (AC) power supply (70, 100), and
the output control circuit (30) is configured to control, based on the magnetic field detection information and a polarity of the AC power supply, the integrated circuit (400) to operate in at least one of the first state and the second state.

5. The integrated circuit according to any one of claims 1 to 4, wherein the output control circuit (30) comprises a first switch (31) and a second switch (32), the first switch (31) and the output port (Pout) are connected in a first current path, the second switch (32) and the output port (Pout) are connected in a second current path having a direction opposite to that of the first current path, and the first switch (31) and the second switch (32) are turned on selectively based on the magnetic field detection information.

6. The integrated circuit according to any one of claims 1 to 4, wherein the output control circuit (30) comprises a first current path in which a current flows out from the output port (Pout), a second current path in which a current flows in from the output port (Pout), and a switch connected in one of the first current path and the second current path, wherein the switch is configured to control, based on the magnetic field detection information, the first current path and the second current path to be turned on selectively.

7. The integrated circuit according to claim 6, wherein no switch is arranged in the other one of the first current path and the second current path.

8. The integrated circuit according to any one of claims 4 to 7, wherein the output control circuit (30) is configured to:
control the load current to flow through the output port (Pout) in a case that the AC power supply (70, 100) is in a positive half cycle and the external magnetic field is a first polarity or in a case that the AC power supply (70, 100) is in a negative half cycle and the external magnetic field is a second polarity opposite to the first polarity, and
control no load current to flow through the output port (Pout) in a case that the AC power supply (70, 100) is in a positive half cycle and the external magnetic field is the second polarity or in a case that the AC power supply (70, 100) is in a negative half cycle and the external magnetic field is the first polarity.

9. The integrated circuit according to any one of claims 1 to 8, wherein the at least one input port comprises a first input port (A1) and a second input port (A2) configured to connect an external AC power supply (70, 100), and the rectifying circuit (60) is configured to convert an AC electrical signal outputted from the external AC power supply (70, 100) into a direct current (DC) electrical signal.

10. The integrated circuit according to claim 9, wherein the rectifying circuit (60) has a voltage output terminal and a ground output terminal, the output control circuit (30) being coupled to the voltage output terminal and the ground output terminal, the load current flowing through the first input port (A1), the rectifying circuit (60), the voltage output terminal and the output control circuit (30) in turn and flowing from the output port (Pout) to the outside of the integrated circuit (400) in a case that the integrated circuit (400) operates in the first state, and/or the load current flowing through the output port (Pout), the output control circuit (30), the ground output terminal, the rectifying circuit (60) and the first input port (A1) in turn in a case that the integrated circuit (400) operates in the second state.

11. A motor assembly, comprising:
a motor (200); and
a motor drive circuit comprising the magnetic sensor integrated circuit (400) according to any one of claims 1 to 10.

12. The motor assembly according to claim 11, wherein
the motor drive circuit further comprises a bidirectional switch (300) connected in series with the motor (200) across the external AC power supply (70, 100); and
the output port (Pout) of the magnetic sensor integrated circuit (400) is connected to a control terminal of the bidirectional switch (300).

13. The motor assembly according to claim 11 or 12, wherein
the motor (200) comprises a stator and a permanent rotor (11), and
the stator comprises a stator core (12) and a single-phase winding (16) wound on the stator core (12).

14. The motor assembly according to claim 11 or 12 or 13, wherein the output control circuit (30) is configured to:
control the bidirectional switch (300) to be turned on in a case that the AC power supply (70, 100) is in a positive half cycle and a magnetic field of the permanent rotor (11) is a first polarity or in a case that the AC power supply (70, 100) is in a negative half cycle and the magnetic field of the permanent rotor (11) is a second polarity opposite to the first polarity, and
control the bidirectional switch (300) to be turned off in a case that the AC power supply (70, 100) is in a negative half cycle and the magnetic field of the permanent rotor (11) is the first polarity or in a case that the AC power supply (70, 100) is in a positive half cycle and a magnetic field of the permanent rotor (11) is the second polarity.

15. The motor assembly according to claim 14, wherein the output control circuit (30) is configured to:
control a current to flow from the integrated circuit (400) to the bidirectional switch (300) in a case that a signal outputted from the AC power supply (70, 100) is in a positive half cycle and the magnetic field of the permanent rotor (11) is the first polarity, and/or
control a current to flow from the bidirectional switch (300) to the integrated circuit (400) in a case that the signal outputted from the AC power supply (70, 100) is in a negative half cycle and the magnetic field of the permanent rotor (11) is the second polarity.
